# FASCICULE DE BREVET EUROPEEN

(11) **EP 2 745 895 B1**
(45) Date de publication et mention de la délivrance du brevet: **28.09.2016**
(21) Numéro de dépôt: 13198598.8
(22) Date de dépôt: 19.12.2013
(51) Int. Cl.: A63G 1/44, A63G 31/10

(54) **PLATEFORME MOBILE DANS UNE STRUCTURE CYLINDRIQUE**
MOBILE PLATTFORM IN EINER ZYLINDRISCHEN STRUKTUR
MOBILE PLATFORM IN A CYLINDRICAL STRUCTURE

(30) Priorité: 20.12.2012 FR 1262501
(43) Date de publication de la demande: 25.06.2014
(73) Titulaire: Aérogroupe, 75015 Paris (FR)
(72) Inventeur: Giacomoni, Jérôme, 92210 Saint-Cloud (FR); Gobbi, Matthieu, 75017 Paris (FR)
(74) Mandataire: Osha Liang

(56) Documents cités:
- WO-A1-2006/095082
- CN-U- 201 768 352
- JP-A- S48 104 336
- US-A- 989 821
- US-A- 1 034 864
- US-A- 1 207 914

## Description

L'invention concerne une plateforme mobile dans une structure cylindrique. Une telle plateforme est conçue pour recevoir des passagers et est destinée à être installée par exemple dans des parcs d'attraction et des lieux touristiques.

### DESCRIPTION DE L'ART ANTERIEUR

Différents systèmes sont connus pour permettre à des passagers de s'élever en altitude et profiter d'une vue dégagée sur un paysage d'intérêt ou tout simplement à des fins d'attraction.

Le brevet américain US 7,926,787 décrit par exemple une plateforme conçue pour recevoir des passagers et un mécanisme d'élévation de la plateforme au moyen de poches gonflables permettant de faire monter et descendre la plateforme.

D'autres systèmes sont connus dans lesquels la plateforme destinée à recevoir les passagers est suspendue. Ces systèmes sont plus impressionnants pour les passagers du fait de la sensation de vide qu'ils ont sous les pieds. Une plateforme suspendue par un câble à la flèche d'une grue est par exemple utilisée pour recevoir des convives et organiser un dîner ou un événement en altitude combinant la restauration et l'attraction (voir la description dur le dite internet www.dinnerinthesky.com). Le brevet publié FR 2882986 au nom de la déposante décrit un système de nacelle suspendue à un ballon lui-même mobile dans une tour, la nacelle pouvant recevoir des passagers. Les systèmes suspendus cités présentent cependant une difficulté d'équilibrage de la plateforme ou de la nacelle une fois les passagers embarqués et l'inconvénient de présenter des éléments au dessus des passagers.

D'une façon plus classique encore, les ascenseurs permettent d'emporter des passagers à l'intérieur d'une cabine. La cabine est soit suspendue à un point fixe central, soit poussée par un système situé en partie basse, par exemple un vérin, réduisant ainsi la sensation ressentie par les passagers. La proximité de la structure porteuse assurant le guidage de la cabine impose de plus, pour d'évidentes raisons de sécurité, de sécuriser les passagers à l'intérieur d'une cabine fermée qui peut, au mieux, être vitrée.

Enfin, d'autres systèmes de plateforme élévatrice sont composés d'un mât (tour) fixe et d'une nacelle latérale ou annulaire entourant le mât et pouvant se translater le long du mât. Dans ces cas, la tour présente un encombrement et une proximité avec la nacelle qui interdit une vue ouverte à 360°. La hauteur d'élévation d'une telle plateforme est par ailleurs limitée du fait des contraintes de stabilité.

US 1,034,864 décrit un dispositif constitué d'une tour comprenant des montants, des renforts et des plateformes. Entre les montants, est montée une piste en spirale. Au centre de la tour, est monté un arbre vertical comprenant des canaux. Autour de l'arbre vertical, est montée une structure comprenant des voitures de transport, ladite structure étant connectée aux canaux et disposée sur la piste en spirale par des roues.

La présente invention présente une plateforme ascensionnelle destinée à recevoir des passagers qui permette une très grande stabilité tout en offrant aux passagers des sensations fortes d'élévation en air libre, avec un minimum d'obstruction pour une vue panoramique.

### RESUME DE L'INVENTION

Selon un premier aspect, l'invention concerne un ensemble comprenant une plateforme destinée à recevoir des passagers, une structure cylindrique, la plateforme étant mobile dans la structure cylindrique. La structure cylindrique comprend selon une variante au moins trois poteaux verticaux. Les trois poteaux peuvent être reliés par des contreventements. La structure cylindrique est par exemple de base circulaire avec des contreventements cintrés en hélice ; ou plus simplement cylindrique à base triangulaire. Par ailleurs, l'ensemble comprend au moins trois chariots solidaires de la plateforme et adaptés à être accrochés à des câbles d'entraînement logés dans des rails de guidage d'au moins trois des poteaux de la structure cylindrique.

Sans rien en dessous ni au-dessus d'eux, les passagers jouissent lors de l'attraction de sensations fortes tout en bénéficiant d'une vue dégagée. La stabilité d'une telle structure permet une élévation à plusieurs dizaines de mètres, voir une centaine de mètres. Il est ainsi possible d'organiser des évènements de type dîners aériens, cocktails, etc.

Selon une variante, l'ensemble comprend pour chaque chariot un mécanisme antichute. Par exemple, le mécanisme antichute comprend un doigt solidaire du chariot et une crémaillère fixée au rail de guidage, le doigt étant destiné à buter contre une dent de la crémaillère en cas de perte de tension dans le câble.

Selon une variante, la plateforme comprend un plateau central et des poutres s'étendant du plateau central et aux extrémités desquelles sont fixés les chariots.

Selon une variante, l'ensemble comporte un moteur associé à chaque câble d'entraînement pour commander le mouvement d'entraînement du câble dans un sens ou dans l'autre.

Selon une variante, l'ensemble comprend une unité de contrôle adaptée à synchroniser les moteurs d'entraînement des câbles.

Selon une variante, l'ensemble comprend un élément de couverture pour la protection des passagers contre les intempéries, fixé au-dessus de la plateforme.

L'élément de couverture est par exemple un élément gonflable de forme ellipsoïdale.

### DESCRIPTION SOMMAIRE DES FIGURES

D'autres aspects et avantages de l'invention apparaîtront à la lecture de la description qui suit, illustrée par les figures suivantes :
Les figures 1A et 1B, des schémas illustrant une plateforme mobile dans une structure cylindrique, selon un exemple de réalisation de l'invention ;
La figure 2, une vue en perspective d'un exemple de réalisation particulier de l'ensemble formé de la structure cylindrique et de la plateforme mobile ;
La figure 3, une vue de détail du système d'entraînement de la plateforme mobile de la figure 2 ;
La figure 4, une vue en perspective d'une plateforme, dans un exemple de réalisation de l'invention.

### DESCRIPTION DETAILLEE DE L'INVENTION

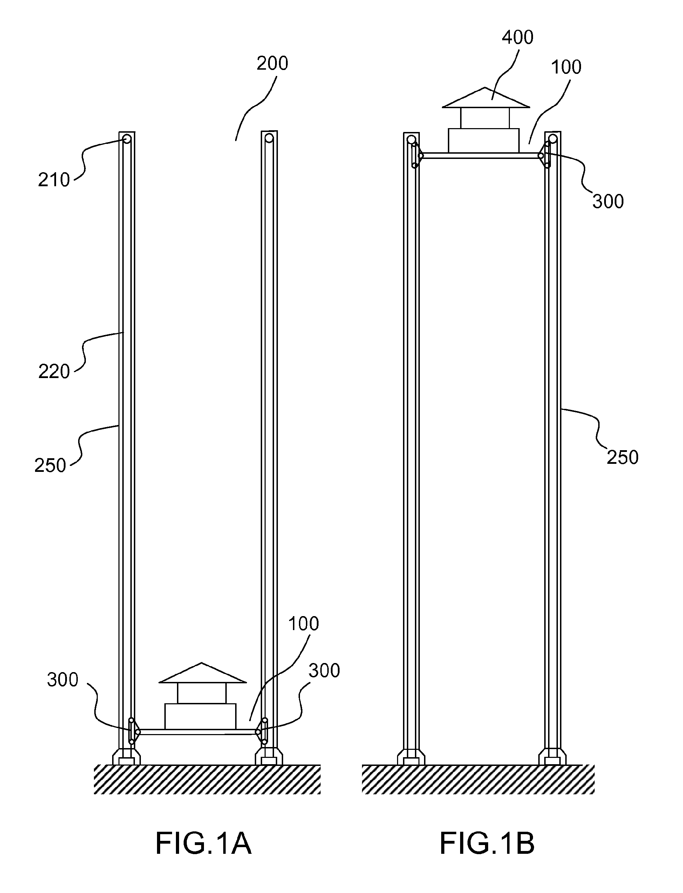

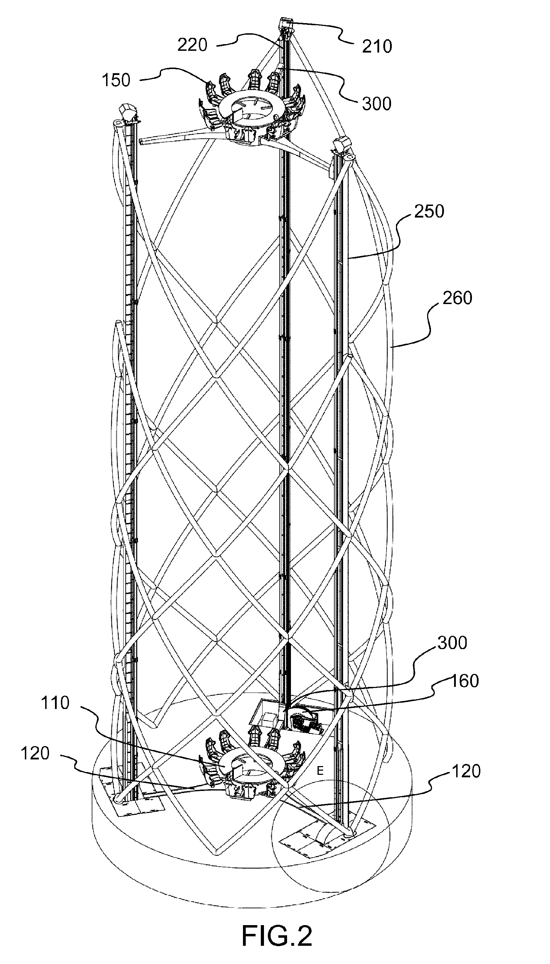

Les figues 1A et 1B illustrent un ensemble formé d'une plateforme 100 et d'une structure cylindrique, ou tour, 200, dans un mode de réalisation de l'invention, respectivement avec la plateforme au sol et avec la plateforme élevée. La figure 2 illustre de façon plus détaillée un exemple de réalisation de l'ensemble illustré sur les figures 1A et 1B.

La tour 200 comprend une structure verticale avec au moins trois poteaux 250 dont deux sont apparents sur les figures 1A et 1B. La tour peut comprendre également des parois entre les poteaux verticaux ou des contreventements reliant les poteaux verticaux pour assurer la rigidité de la structure, par exemple des contreventements 260 formant des traverses ou des hélices croisées, comme cela est illustré sur la figure 2. Les poteaux et les contreventements sont par exemple métalliques, en tube ou en profilés.

Selon la présente invention, la plateforme 100 destinée à recevoir des passagers est mobile dans la tour 200. Elle est par exemple entraînée en ascension dans la tour par des câbles 220 d'un système d'entraînement.

Dans l'exemple des figures 1A, 1B et 2, la tour est sensiblement cylindrique de base circulaire et la plateforme de forme circulaire est munie de bras ou poutres permettant son éloignement de la tour. Cette forme n'est cependant pas limitative, la section de la structure cylindrique formant la tour pouvant être quelconque, par exemple hexagonale, triangulaire, ou carrée.

Comme cela est illustré sur la figure 2, la plateforme 100 comprend éventuellement des sièges 150 pour embarquer des passagers. Les sièges sont par exemple répartis autour d'un plateau central 110 de la plateforme, lui-même relié au système d'entraînement par des poutres ou bras 120. Les sièges peuvent être tournés vers l'intérieur ou vers l'extérieur de la tour. Dans le premier cas, les passagers profitent d'une plus grande convivialité ; dans le second cas, ils ont une vue directe sur le panorama. Les sièges peuvent aussi pivoter sur eux-mêmes faisant ainsi profiter les passagers d'une vue à 360°. La plateforme peut comprendre également un élément de couverture, ou toit 400, permettant de protéger les passagers des intempéries. La plateforme n'étant pas suspendue mais directement reliée au système d'entraînement, la stabilité est nettement améliorée et un nombre important de passagers peut être répartis autour du plateau central, même de façon irrégulière. Les passagers sont par exemple répartis sur un cercle qui doit présenter un diamètre suffisant pour installer confortablement tous les passagers.

La tour peut présenter une hauteur comprise entre 30 m et 80 m afin de permettre une bonne vue panoramique lorsque des passagers sont élevés au moyen de la plateforme. Par ailleurs, la plateforme étant directement reliée au système d'entraînement, il est possible pour les passagers, dans la position élevée (figure 1B) de la plateforme, d'avoir une vue complètement dégagée, y compris de la structure elle-même.

Les poteaux 250 comprennent par exemple des rails de guidage dans lesquels sont placés les câbles d'entraînement 220, par exemple des câbles de type de ceux utilisés pour les ascenseurs. Les rails de guidage sont adaptés pour accueillir respectivement trois chariots 300 solidaires de chacune des extrémités des poutres 120 de la plateforme. Chaque câble peut s'étendre depuis un treuil 160 situé à la base de la tour jusqu'à une poulie de renvoie 210 située au sommet de la tour et présente un brin de retour depuis la poulie 210 vers le treuil 160. Le treuil peut être du type de ceux utilisés pour des installations d'ascenseurs ; il peut être associé à une unité de commande pour contrôler le sens de rotation du câble 220 et réguler sa vitesse ; l'unité de commande reçoit aussi la synchronisation du mouvement des trois chariots de façon à ce que la plateforme monte bien droit dans la tour, c'est à dire en conservant le plateau central 110 horizontal.

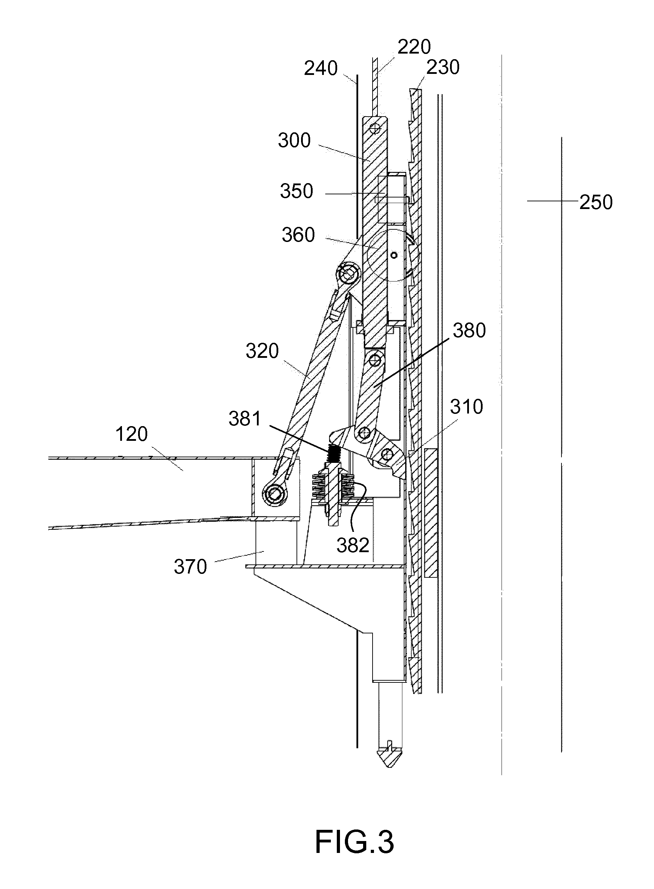

La figure 3 montre une vue en détail du système d'entraînement de la plateforme selon un exemple de réalisation. La figure 3 montre une portion d'un poteau 250 de la tour et une portion d'une poutre 120 reliée au plateau central de la plateforme. La figure 3 montre également un chariot 300 logé dans des rails de guidage du poteau 250 et accroché à un câble d'entraînement 220. Le câble 220 présente deux brins de câble de part et d'autre de la poulie de renvoie 210 (figure 1A, 1B) ; un premier brin de câble sur lequel est accroché le chariot définissant un chemin d'entraînement et un deuxième brin de câble définissant un chemin de retour vers le treuil d'enroulement du câble 160. Chaque treuil peut être associé à un moteur pour commander le mouvement du câble dans un sens ou dans l'autre. On peut par exemple avoir trois moteurs synchronisés par une unité électronique pour commander le mouvement de trois câbles pour entraîner trois chariots du ballon le long de trois poteaux de la tour. On peut bien sûr avoir plus de trois chariots et plus de trois moteurs lorsque la tour présente plus de trois poteaux verticaux. On peut aussi avoir un seul moteur commandant le mouvement de trois câbles.

La figure 3 montre aussi une vue en coupe latérale d'un chariot 300 de forme sensiblement parallélépipédique adapté à un profilé en C (240) à l'intérieur duquel il coulisse. Le profilé en C est accroché à un poteau 250 de la structure porteuse cylindrique. Le chariot est tracté par le câble 220. Des roulettes latérales 350 par exemple au nombre de 4 sont en appui sur les cotés droit et gauche du profilé en C. Des roulettes transversales 360 sont en appuis sur le fond du profilé en C ou sur ces retours. Les bras ou poutres 120 de la plateforme repose sur le sabot du chariot par l'intermédiaire d'un élément souple amortissant 370 de type silentbloc^{®} qui assure une interface souple. Une élingue 320 suspend le bras au chariot. Sa longueur est réglable de façon à régler la répartition des efforts entre l'élingue (traction) et le silentbloc (compression) et obtenir un comportement optimisé de la plateforme. Une plus forte traction dans les élingues se traduira par une plus grande liberté de mouvement de la plateforme. Une compression plus forte du silentbloc se traduira par un recentrage plus contraignant de la plateforme.

L'utilisation de plusieurs moteurs synchronisés pour commander le mouvement de plusieurs câbles d'entraînement des chariots apporte une redondance en cas de panne ou de rupture d'un câble afin d'améliorer la sécurité des passagers. Si un câble se rompt, le chariot accroché à ce câble glissera le long du poteau par gravité, ce qui fera basculer la plateforme vers le poteau au câble rompu. Cette bascule, même sans danger pour la sécurité, peut cependant effrayer les passagers. On peut donc prévoir, sur chaque chariot 300, un mécanisme antichute. En fonctionnement normal, le câble 220 retient le poids du chariot et de la plateforme. La tension dans le câble 220 entraine un mouvement de translation verticale de la bielle 380. Le ressort 381 est allongé et le doigt 310 est rétracté à l'intérieur du chariot. En cas de rupture du câble 220, la tension dans le câble disparait, et la bielle est libre de se translater vers le bas tirée par le ressort 381 et faisant basculer le doigt 310 vers l'extérieur du chariot. Le chariot chute alors librement jusqu'à ce que le doigt 310 en saillie vienne buter contre une dent de la crémaillère 230 fixée au fond et au centre du C. Le ressort 382 permet d'amortir le choc en butée de la bielle et donc l'arrêt du chariot et de la plateforme.

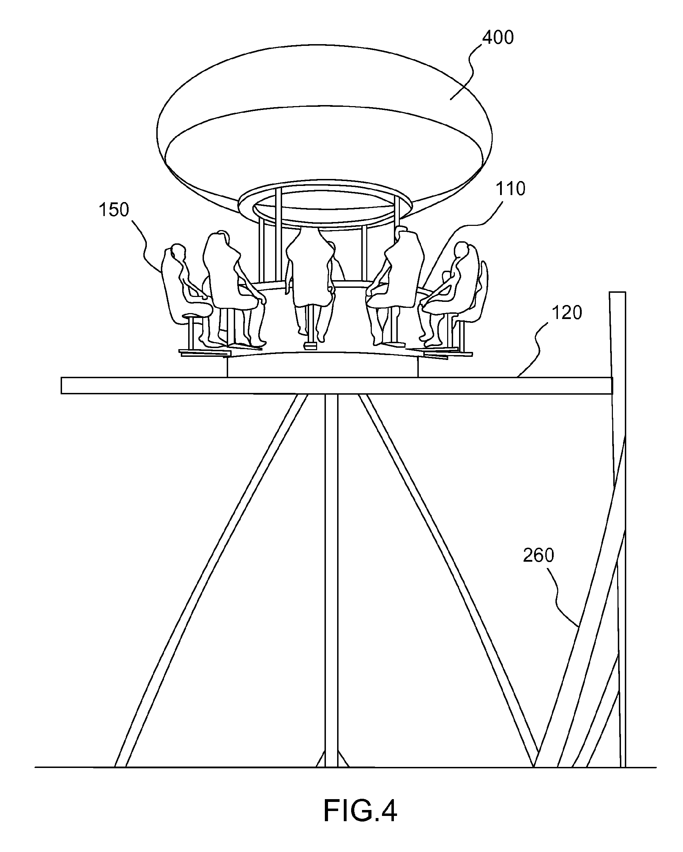

La figure 4 illustre un exemple de réalisation d'une plateforme, comprenant un plateau central 110 relié à la structure cylindrique par des poutres 120. Le plateau central est par exemple équipé de sièges 150 pour les passagers, répartis autour d'une structure formant un bar. L'ensemble du bar et des passagers est protégé par un élément de couverture 400. L'élément de couverture peut être quelconque et pourra comporter par exemple une enseigne publicitaire. Il pourra s'agir par exemple d'un élément gonflable. Avantageusement, cet élément gonflable pourra présenter une forme ellipsoïdale, comme présenté sur la figure 4 afin de présenter une résistance minimum au vent lorsque la plateforme est en position élevée et que l'élément de couverture dépasse du bord supérieur de la tour.

Bien que décrite à travers un certain nombre d'exemples de réalisation détaillés, l'ensemble formé de la plateforme mobile et de la structure cylindrique dans laquelle la plateforme est destinée à élever comprend différentes variantes, modifications et perfectionnements qui apparaîtront de façon évidente à l'homme de l'art, étant entendu que ces différentes variantes, modifications et perfectionnements font partie de la portée de l'invention, telle que définie par les revendications qui suivent.

## Revendications

1. Ensemble comprenant :
- une plateforme (100) destinée à recevoir des passagers,
- une structure cylindrique (200) comprenant au moins trois poteaux verticaux (250), la plateforme étant mobile dans la structure cylindrique,
l'ensemble étant **caractérisé en ce qu'**il comporte au moins trois chariots (300) solidaires de la plateforme et adaptés à être accrochés à des câbles d'entraînement (220) logés dans des rails de guidage d'au moins trois des poteaux de la structure cylindrique.

2. Ensemble selon la revendication 1, comprenant en outre, pour chaque chariot, un mécanisme antichute comprenant un doigt (310) solidaire du chariot et une crémaillère (230) fixée au rail de guidage, le doigt étant destiné à buter contre une dent de la crémaillère en cas de perte de tension dans le câble.

3. Ensemble selon l'une des revendications 1 ou 2, **caractérisé en ce que** la plateforme (100) comprend un plateau central (110) et des poutres (120) s'étendant du plateau central, les chariots étant fixés aux extrémités des poutres.

4. Ensemble selon l'une des revendications 1 à 3, **caractérisé en ce qu'**il comporte un moteur associé à chaque câble d'entraînement pour commander le mouvement d'entraînement du câble dans un sens ou dans l'autre.

5. Ensemble selon la revendication 4, **caractérisé en ce qu'**il comprend une unité de contrôle adaptée à synchroniser les moteurs d'entraînement des câbles.

6. Ensemble selon l'une des revendications 1 à 5, **caractérisé en ce qu'**il comprend un élément de couverture (400) pour la protection des passagers contre les intempéries, fixé au-dessus de la plateforme.

7. Ensemble selon la revendication 6, **caractérisé en ce que** l'élément de couverture est un élément gonflable de forme ellipsoïdale.

## Patentansprüche

1. Einheit, bestehend aus:
- einer Plattform (100), zur Aufnahme von Passagieren bestimmt,
- einer zylindrischen Struktur (200), die mindestens drei vertikale Pfosten (250) umfasst, wobei die Plattform in der zylindrischen Struktur mobil ist,
wobei die Einheit dadurch charakterisiert ist, dass sie mindestens drei Wagen (300) umfasst, die fest mit der Plattform verbunden sind und geeignet sind, an Antriebskabeln (220) aufgehängt zu werden, die in Führungsschienen von mindestens drei der Pfosten der zylindrischen Struktur untergebracht sind.

2. Einheit nach Anspruch 1, die unter anderem für jeden Wagen einen Auffang-Mechanismus umfasst, der einen Finger (310) aufweist, der fest mit dem Wagen verbunden ist, und eine Zahnstange (230), die an der Führungsschiene befestigt ist, wobei der Finger dazu bestimmt ist, gegen einen Zahn der Zahnstange anzuliegen, falls es im Kabel zu einem Spannungsverlust kommt.

3. Einheit nach einem der Ansprüche 1 oder 2, **dadurch gekennzeichnet, dass** die Plattform (100) ein Mittelplateau (110) und Träger (120) umfasst, die vom Mittelplateau aus abgehen, wobei die Wagen an den Enden der Träger befestigt sind.

4. Einheit nach einem der Ansprüche 1 bis 3, **dadurch gekennzeichnet, dass** sie einen mit jedem Antriebskabel verbundenen Motor umfasst, um die Antriebsbewegung des Kabels in die eine Richtung oder in die andere zu steuern.

5. Einheit nach Anspruch 4, **dadurch gekennzeichnet, dass** sie eine Kontrollanlage umfasst, die geeignet ist, die Antriebsmotoren der Kabel zu synchronisieren.

6. Einheit nach einem der Ansprüche 1 bis 5, **dadurch gekennzeichnet, dass** sie ein Abdeckelement (400) für den Schutz der Passagiere vor schlechter Witterung umfasst, das über der Plattform befestigt ist.

7. Einheit nach Anspruch 6, **dadurch gekennzeichnet, dass** das Abdeckelement ein aufblasbares Element von elliptischer Form ist.

## Claims

1. An assembly comprising:
- a platform assembly (100) intended to receive passengers,
- a cylindrical structure (200) comprising at least three vertical posts (250), the platform assembly being mobile within the cylindrical structure,
the assembly being **characterized in that** it comprises at least three carriages (300) fastened to the platform assembly and adapted to be attached to drive cables (220) accommodated in guide rails of at least three of the posts of the cylindrical structure.

2. The assembly according to claim 1, further comprising, for each carriage, a fall-preventing mechanism comprising a finger (310) fastened to the carriage and a rack (230) fixed to the guide rail, the finger being intended to abut against a tooth of the rack in the event of loss of tension in the cable.

3. the assembly according to any of claims 1 or 2, **characterized in that** the platform assembly (100) comprises a central platform (110) and beams (120) extending from the central platform, the carriages being fixed to the ends of the beams.

4. The assembly according to any of claims 1 to 3, **characterized in that** it comprises a motor associated with each drive cable to drive the cable in one direction or the other.

5. The assembly according to claim 4, **characterized in that** it comprises a control unit adapted to synchronize the cable drive motors.

6. The assembly according to any of claims 1 to 5, **characterized in that** it comprises a cover (400) for protecting passengers against inclement weather, fixed above the platform assembly.

7. The assembly according to claim 6, **characterized in that** the cover is inflatable and of ellipsoidal shape.
